# EUROPEAN PATENT APPLICATION

(11) **EP 1 808 903 A2**
(43) Date of publication of application: **18.07.2007**
(21) Application number: 06256585.8
(22) Date of filing: 27.12.2006
(51) Int. Cl.: H01L 33/00

(54) **Method of manufacturing a semiconductor light emitting apparatus**

(30) Priority: 11.01.2006 JP 2006004085
(71) Applicant: SHINKO ELECTRIC INDUSTRIES CO., LTD., Nagano-shi, Nagano 381-2287 (JP)
(72) Inventor: Taguchi, Yuichi, c/o Shinko Electric Ind. Co. Ltd., Nagano-shi, Nagano 381-2287 (JP); Shiraishi, Akinori, c/o Shinko Elec. Ind. Co. Ltd., Nagano-shi, Nagano 381-2287 (JP); Murayama, Kei, c/o Shinko Elec. Ind. Co. Ltd., Nagano-shi, Nagano 381-2287 (JP); Koizumi, Naoyuki, c/o Shinko Elec. Ind. Co. Ltd., Nagano-shi, Nagano 381-2287 (JP); Sunohara, Masahiro, c/o Shinko Elec. Ind. Co. Ltd., Nagano-shi, Nagano 381-2287 (JP); Sakaguchi, Hideaki, c/o Shinko Elec. Ind. Co. Ltd., Nagano-shi, Nagano 381-2287 (JP); Higashi, Mitsutoshi, c/o Shinko Elec Ind. Co. Ltd., Nagano-shi, Nagano 381-2287 (JP)
(74) Representative: Rees, Alexander Ellison

(57) **Abstract**

A method of manufacturing a light emitting apparatus including a light emitting device and a light emitting device installing body having a concave part for installing the light emitting device therein is disclosed. The method includes the steps of a) forming a coating of plural fluorophor particles covering the light emitting device installed in the concave part, and b) forming a transparent resin covering the plural fluorophor particle coating. Step b) includes a step of performing illumination with the light emitting device so that the light emitted from the light emitting apparatus has a predetermined luminance and chromaticity.

## Description

### BACKGROUND OF THE INVENTION

### 1. Field of the Invention

The present invention generally relates to a light emitting apparatus, and more particularly to a method of manufacturing a light emitting apparatus for facilitating adjustment of luminance and chromaticity of the light emitting apparatus.

### 2. Description of the Related Art

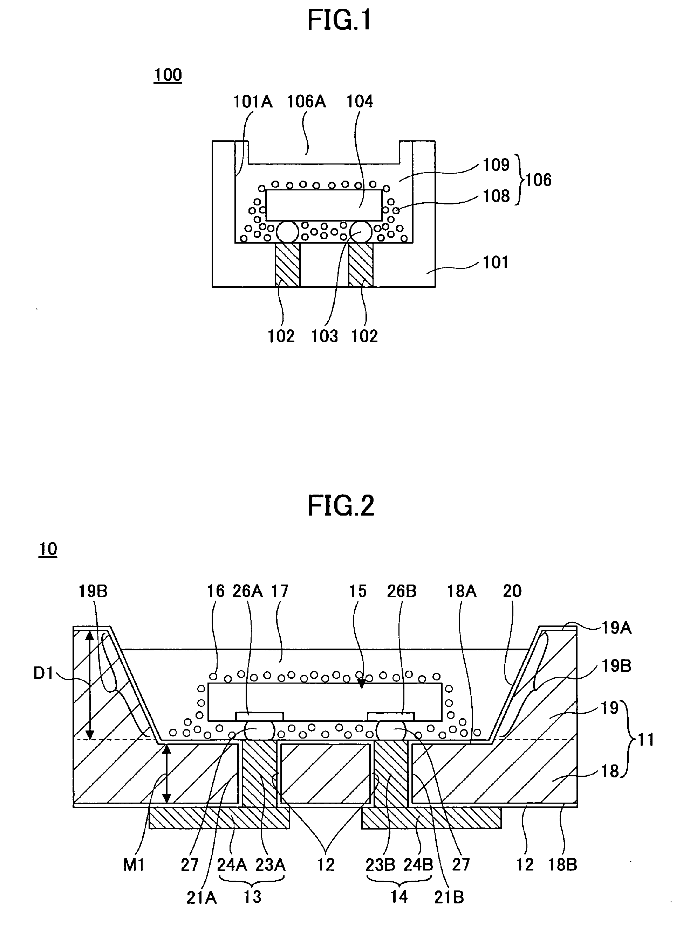

For a light emitting apparatus, it is essential for the light of its light emitting device transmitted through a fluorophor (light emitted from the light emitting apparatus) to have a predetermined luminance and chromaticity. However, there is a problem of inconsistency of luminance and chromaticity of the light emitted from the light emitting apparatus due to, for example, inconsistency of the characteristics among light emitting devices (more specifically, luminance and chromaticity) and inconsistency of the thickness of the fluorophor. One example of the light emitting apparatus having its chromaticity adjusted is shown in Fig.1.

Fig.1 is a cross-sectional view showing a light emitting apparatus 100 according to a related art case.

In Fig.1, the light emitting apparatus 100 includes a light emitting device installing body 101, a penetrating via(s) 102, a light emitting device 104, and a fluorophor containing resin 106. The light emitting device installing body 101 has a concave part 101A for installing the light emitting device 104 therein. The penetrating via 102 is formed in a manner penetrating the light emitting device installing body 101. The light emitting device 104 is electrically connected to the penetrating via 102 via a bump(s) 103.

The fluorophor containing resin 106 hermetically seals the light emitting device 104 installed in the concave part 101A. The fluorophor containing resin 106 has fluorophor particles 108 dispersed in a transparent resin 109. The fluorophor particles 108 are provided in a manner covering the light emitting device 104. The fluorophor particles 108 have a specific gravity greater than the transparent resin 109. Therefore, the proportion of the fluorophor particles 108 in the fluorophor resin becomes less as their position becomes higher with respect to the light emitting device 104. In other words, there is a lot of fluorophor particles 108 existing at a lower part of the fluorophor containing resin 106 while there is many transparent resin 109 existing at an upper part of the fluorophor containing resin 106.

A concave part 106A is formed at an upper part of the fluorophor containing resin 106. The concave part 106A is for adjusting the thickness of the transparent resin 109 so that the light emitted from the light emitting apparatus 100 can attain a predetermined chromaticity.

The concave part 106A is formed by repetitively conducting a process of polishing the transparent resin 109 provided at the upper part of the fluorophor containing resin 106 and a process of inspecting whether the chromaticity of the light emitting apparatus 100 with its polished transparent resin 109 has reached a predetermined chromaticity.

By providing the concave part 106A that adjusts the thickness of the transparent resin 109, the chromaticity of the light emitted from the light emitting apparatus 100 can be adjusted (See, for example, Japanese Laid-Open Patent Application No.2004-186488).

However, in adjusting the light emitted from the light emitting apparatus 100, the light emitting apparatus 100 must repetitively conduct the processes of grinding the transparent resin 109 and inspecting whether the chromaticity of the light emitting apparatus 100 has reached a predetermined chromaticity after the polishing process. Therefore, it is difficult to adjust the chromaticity of the light emitted from the light emitting apparatus 100.

### SUMMARY OF THE INVENTION

The present invention may provide a method of manufacturing a light emitting apparatus that substantially obviates one or more of the problems caused by the limitations and disadvantages of the

### related art.

Features and advantages of the present invention will be set forth in the description which follows, and in part will become apparent from the description and the accompanying drawings, or may be learned by practice of the invention according to the teachings provided in the description. Objects as well as other features and advantages of the present invention will be realized and attained by a method of manufacturing a light emitting apparatus particularly pointed out in the specification in such full, clear, concise, and exact terms as to enable a person having ordinary skill in the art to practice the invention.

To achieve these and other advantages and in accordance with the purpose of the invention, as embodied and broadly described herein, an embodiment of the present invention provides a method of manufacturing a light emitting apparatus including a light emitting device and a light emitting device installing body having a concave part for installing the light emitting device therein, the method including the steps of: a) forming a coating of a plurality of fluorophor particles covering the light emitting device installed in the concave part; and b) forming a transparent resin covering the plural fluorophor particles; wherein step b) includes a step of performing illumination with the light emitting device so that the light emitted from the light emitting apparatus has a predetermined luminance and chromaticity.

In the method of manufacturing a light emitting apparatus according to an embodiment of the present invention, step a) may include a step of forming the coating of the plural fluorophor particles with a substantially even thickness.

In the method of manufacturing a light emitting apparatus according to an embodiment of the present invention, the transparent resin may be formed by an inkjet method.

Other objects and further features of the present invention will be apparent from the following detailed description when read in conjunction with the accompanying drawings.

### BRIEF DESCRIPTION OF THE DRAWINGS

Fig. 1 is a cross-sectional view showing a light emitting apparatus of a related art case;
Fig.2 is a cross-sectional view showing a light emitting apparatus according to an embodiment of the present invention;
Fig.3 is a plan view of a base material on which a light emitting apparatus according to an embodiment of the present invention is formed; and
Figs.4-16 are schematic diagrams for describing the steps in a method of manufacturing a light emitting apparatus according to an embodiment of the present invention.

### DESCRIPTION OF THE PREFERRED EMBODIMENTS

In the following, embodiments of the present invention will be described with reference to the accompanying drawings.

Fig.2 is a cross-sectional view showing a light emitting apparatus 10 according to an embodiment of the present invention.

In Fig.2, the light emitting apparatus 10 according to an embodiment of the present invention includes a light emitting device installing body 11, a insulating film 12, wiring patterns 13, 14, a light emitting device 15, fluorophor particles 16, and a transparent resin 17.

The light emitting device installing body 11 includes a plane part 18, a frame part 19, and a concave part 20. The plane part 18 is for supporting the frame part 19. The plane part 18 and the frame part 19 are integrally formed, that is, formed as a united body. The plane part 18 includes plural penetrating holes 21A, 21B. The plane part 18 can be formed having a thickness M1 of, for example, 200 *µ*m. The frame part 19 is provided on top of the plane part 18 and is integrally formed with the plane part 18, as described above. The frame part 19 has an inner wall 19B formed with an inclined surface.

The concave part 20 is for installing the light emitting device 15. The concave part 20 is composed of an upper surface 18A of the plane part 18 and the inner wall 19B of the frame part 19. The concave part 20 becomes wider in a direction from the upper surface 18A of the plane part 18 toward an upper surface 19A of the frame part 19. The concave part 20 is formed by, for example, anisotropic etching a base material of the light emitting device installing body 11. The concave part 20 can be formed with a depth D1, of, for example, 200 µm. The material of the light emitting device installing body 11 (base material of the light emitting device installing body 11) is, for example, silicon, glass, or the like.

The insulating film 12 is provided in a manner covering the surface of the light emitting device installing body 11 (including the surface of the penetrating holes 21A, 21B). The insulating film 12 is for insulating between the light emitting device installing body 11 and the wiring patterns 13, 14. For example, an oxide film may be used as the insulating film 12. Furthermore, the insulating film 12 can be formed with a thickness of, for example, 1 µm.

The wiring pattern 13 includes a via part 23A and a wiring part 24A. The via part 23A is provided in the penetrating hole 21A in which the insulating film 12 is formed. An upper end part of the via part 23A is electrically connected to an electrode 26A of the light emitting device 15. A lower end part of the via part 23A is connected to the wiring part 24A. For example, a conductive metal (e.g. Cu) may be used as the material of the via part 23A.

The wiring part 24A is provided at a lower surface 18B of the plane part 18 on which the insulating film 12 is formed. The wiring part 24A is connected to a lower end part of the via part 23A. Thereby, the wiring part 24A is electrically connected to the electrode 26A of the light emitting device 15 via the via part 23A. The wiring part 24A functions as an external connecting terminal of the light emitting apparatus 10. For example, a conductive metal may be used as the material of the wiring part 24A. More specifically, the material of the wiring part 24A may be a Ni/Au layered film having a Ni layer and a Au layer formed on the insulating film 12 in this order.

The wiring pattern 14 includes a via part 23B and a wiring part 24B. The via part 23B is provided in the penetrating hole 21B in which the insulating film 12 is formed. An upper end part of the via part 23B is electrically connected to an electrode 26B of the light emitting device 15. A lower end part of the via part 23B is connected to the wiring part 24B. For example, a conductive metal (e.g. Cu) may be used as the material of the via part 23B.

The wiring part 24B is provided at a lower surface 18B of the plane part 18 on which the insulating film 12 is formed. The wiring part 24B is connected to a lower end part of the via part 23B. Thereby, the wiring part 24B is electrically connected to the electrode 26B of the light emitting device 15 via the via part 23B. The wiring part 24B functions as an external connecting terminal of the light emitting apparatus 10. For example, a conductive metal may be used as the material of the wiring part 24B. More specifically, the material of the wiring part 24B may be a Ni/Au layered film having a Ni layer and a Au layer formed on the insulating film 12 in this order.

The light emitting device 15 is installed in the concave part 20 of the light emitting device installing body 11 and is connected to the wiring patterns 13, 14 by a flip chip method. The light emitting device 15 emits light of a predetermined color. The light emitting device 15 includes electrodes 26A and 26B. One of the electrodes 26A, 26B is a positive electrode and the other one of the electrodes 26A, 26B is a negative electrode. The electrode 26A is electrically connected to the wiring pattern 13 via a bump 27. Thereby, the light emitting device 15 is electrically connected to the wiring patterns 13, 14.

For example, a light emitting diode (LED) device may be used as the light emitting device 15. For example, in a case where the light emitting apparatus 10 emits white light, a blue light emitting diode (LED) device may be used.

A coating including plural fluorophor particles 16 is provided in a manner covering the light emitting device 15. The fluorophor particles 16 are evenly (uniformly) coated on the light emitting diode 15 so that the coating of the fluorophor particles 16 covering the light emitting diode has substantially an even thickness. By forming the coating of fluorophor particles covering the light emitting diode 15 with substantially an even thickness, the inconsistency of luminance and chromaticity of the light emitted by the light emitting apparatus 10 can be restrained.

For example, in a case where the light emitting apparatus 10 emits white light, YAG fluorophor particles may be used in the fluorophor particle coating 16. The fluorophor particles 16 can be formed having an average particle diameter of, for example, 20 µm. For example, a spray coating method may be used to form the fluorophor particle coating 16.

The transparent resin 17 is provided in the concave part 20. The transparent resin 17 hermetically seals the light emitting device 15 being covered by the fluorophor particle coating 16. By changing the thickness of the transparent resin 17, luminance and chromaticity of the light emitted by the light emitting apparatus 10 can be adjusted. The transparent resin 17 is formed with a thickness so that the light emitted by the light emitting apparatus 10 can have a predetermined luminance and chromaticity. For example, an epoxy resin or an acrylic resin may be used as the transparent resin 17.

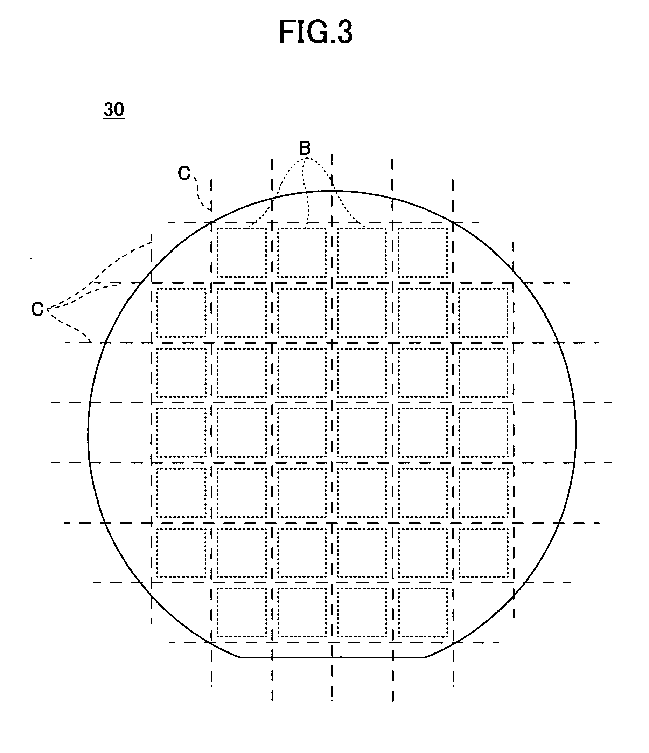

Fig.3 is a plan view showing a base material 30 on which the light emitting apparatus is formed according to an embodiment of the present invention.

In Fig.3, "B" indicates the areas at which the light emitting apparatus 10 is formed (hereinafter referred to as "light emitting apparatus formation area B"), and "C" indicates the areas at which the base material is 30 is cut (hereinafter referred to as "cutting area C").

In this example, plural light emitting apparatuses 10 are formed on the plural light emitting apparatus formation areas B of the base material 30. For example, a silicon wafer may be used as the base material 30.

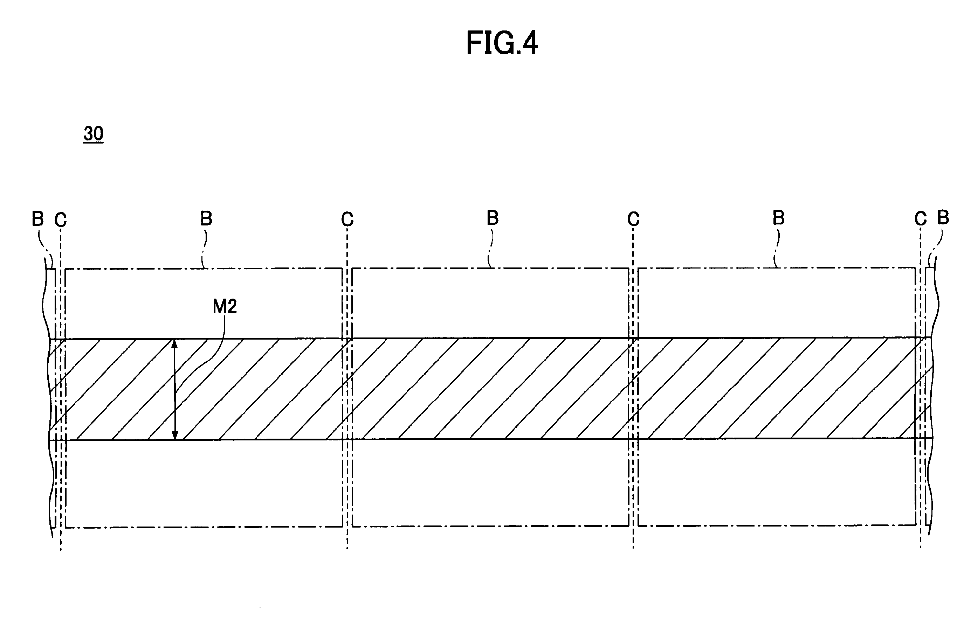

Figs.4-16 are schematic diagrams for describing the steps in a method of manufacturing a light emitting apparatus according to an embodiment of the present invention. In Figs.4-16, like parts of the light emitting apparatus 10 are denoted with the same reference numerals as of Figs.2 and 3.

A method of manufacturing a light emitting apparatus 10 according to an embodiment of the present invention is described with reference to Figs.4-16. The below-described method of manufacturing a light emitting apparatus 10 is described as a case of forming plural light emitting apparatuses 10-1 through 10-3 on the base material 30 shown in Fig.3. With the exception that the light emitting devices 15-1 through 15-3 provided in the light emitting apparatuses 10-1 through 10-3 have different luminance and chromaticity, each of the plural light emitting apparatuses 10-1 through 10-3 has the same configuration as the above-described light emitting apparatus 10. Furthermore, the following describes an exemplary case of manufacturing plural light emitting apparatuses 10-1 through 10-3 with predetermined luminance and chromaticity by applying transparent resins 17-1 through 17-3 having different thickness to the fluorophor particle coating 16 covering the light emitting devices 15-1 through 15-3 having different luminances and chromaticities.

Fig.4 shows a step of preparing the base material 30 having plural light emitting apparatus formation areas B. A silicon substrate may be used as the base material 30. Furthermore, the thickness M2 of the base material is, for example, 400 *µ*m.

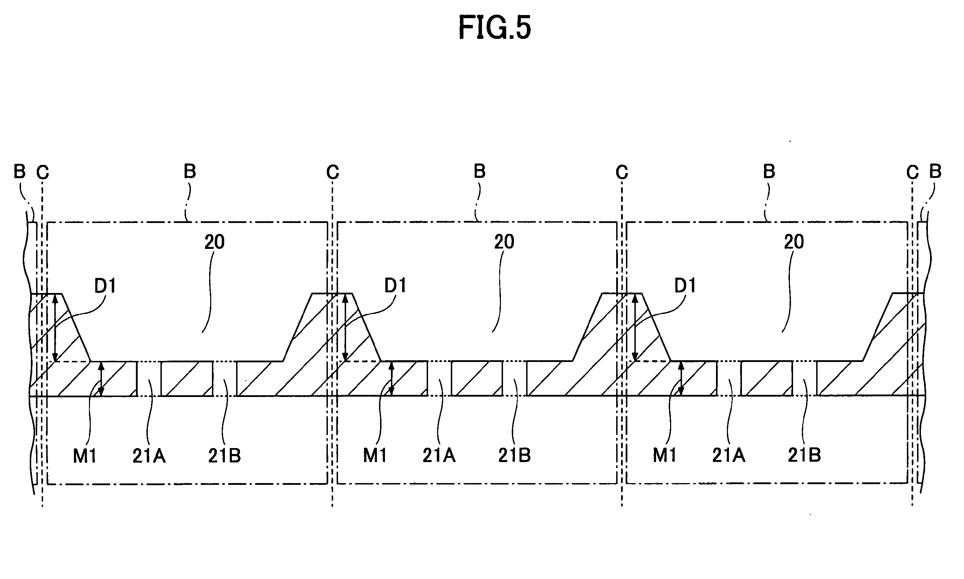

Next, Fig.5 shows a step of etching the base material 30, and forming penetrating holes 21A, 21B and a concave part 20 in a corresponding light emitting device formation area B of the base material 30. Thereby, plural structures corresponding to the above-described light emitting device installing body are formed on the base material 30. The depth D1 of the concave part 20 is, for example, 200 *µ*m. The thickness M1 of the part corresponding to the above-described plane part 18 is, for example, 200 µm.

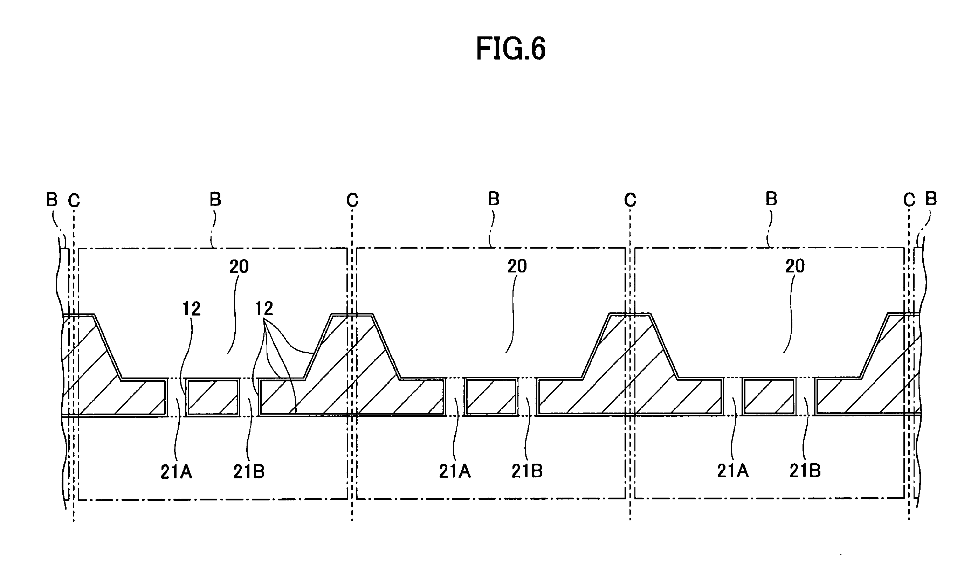

Next, Fig.6 shows a step of forming an insulating film 12 in a manner covering the surface of the base material to which the penetrating holes 21A, 21B and concave part 20 are formed (said surface includes the surface of the walls of the penetrating holes 21A, 21B formed in the base material 30). The insulating film 12 is, for example, an oxide film. For example, in a case where the base material is a silicon substrate, the insulating film 12 may be formed by thermally oxidizing the base material 30. The thickness of the insulating film is, for example, 1 µm.

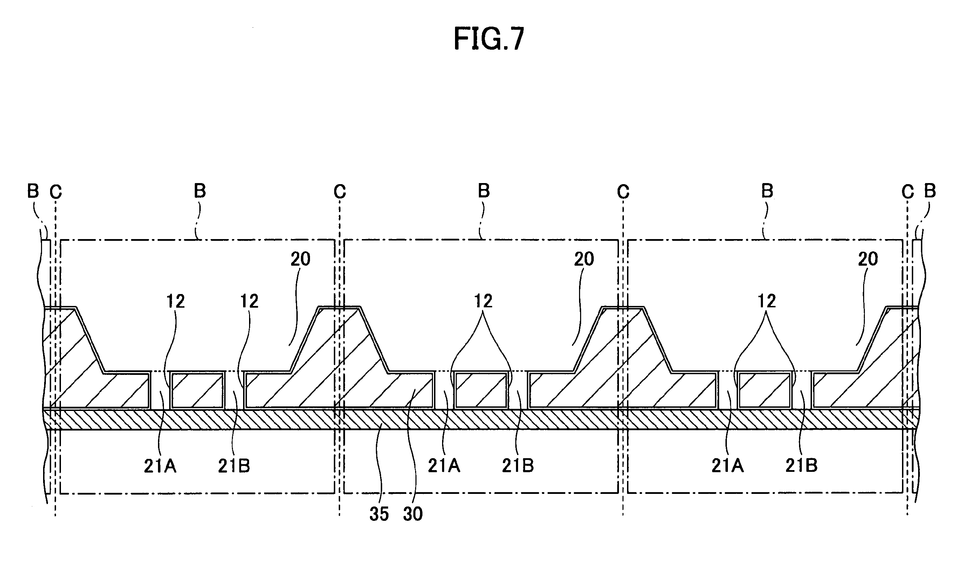

Next, Fig.7 shows a step of adhering a metal foil 35 on a lower surface of the plural structures shown in Fig.6. The metal foil 35 serves as a feeding layer when growing (precipitating) a metal film on the penetrating holes 21A, 21B. For example, a Cu foil may be used as the metal foil 35.

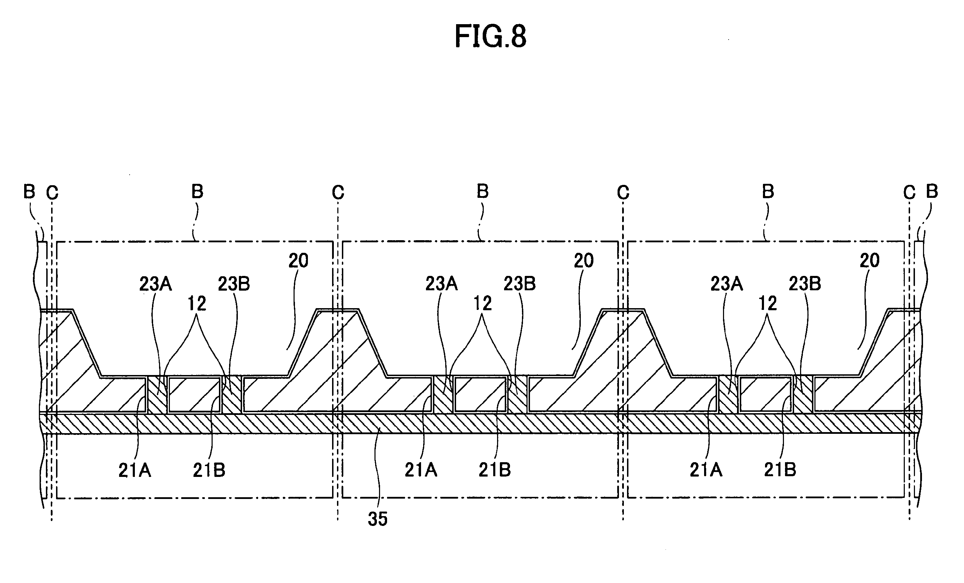

Next, Fig.8 shows a step of forming via parts 21A, 21B by supplying (filling) the penetrating film 21A, 21B by growing a metal film using an electroplating method. The metal film to fill in the penetrating holes 21A, 21B is, for example, the Cu film.

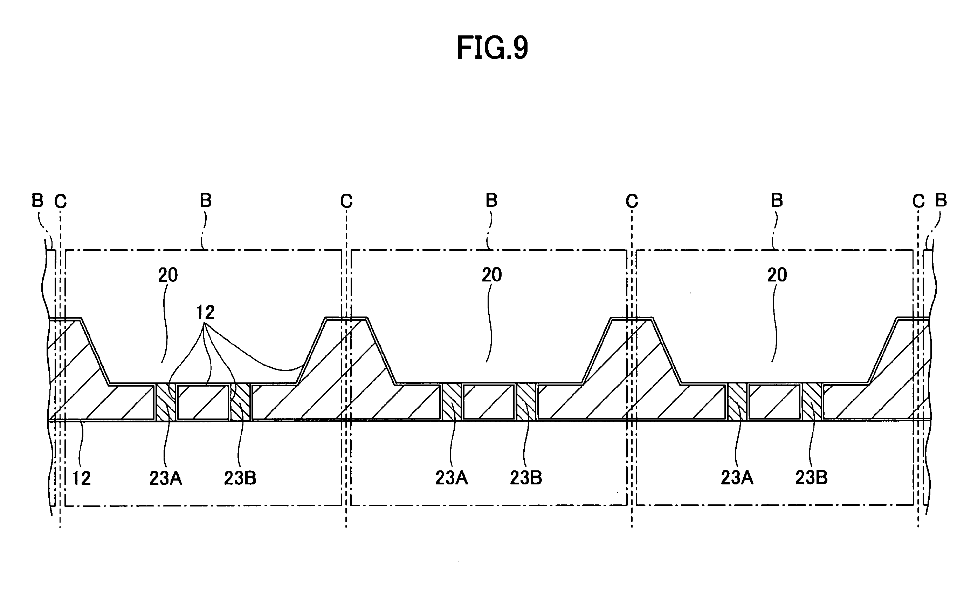

Next, Fig.9 shows a step of removing the metal foil 35 by etching.

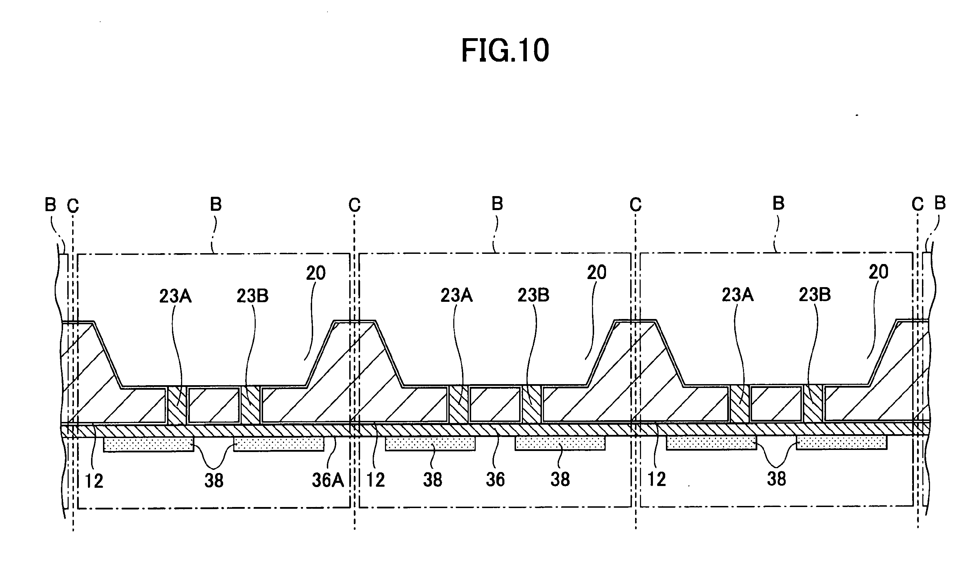

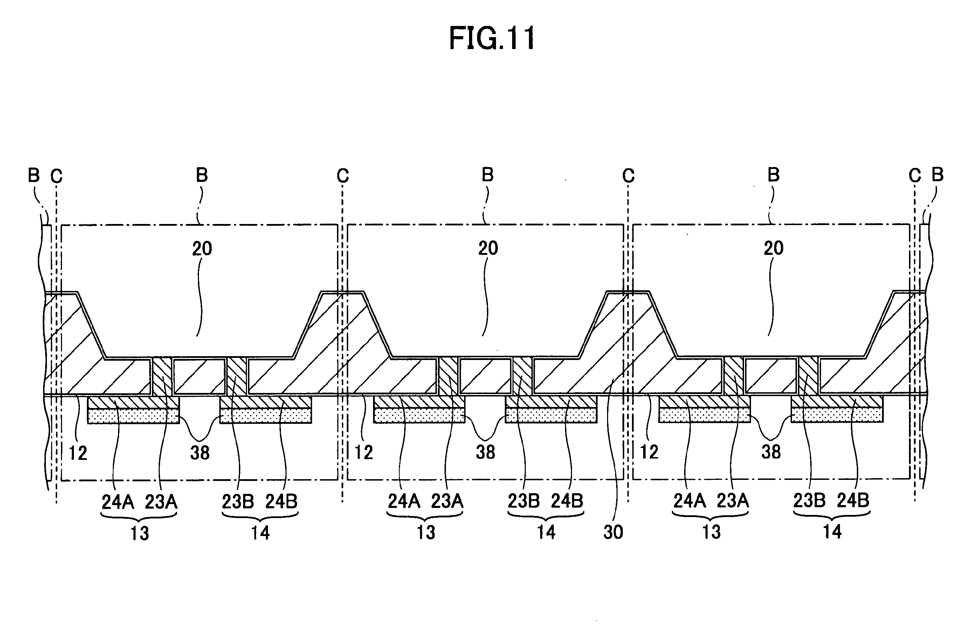

Next, Fig.10 shows a step of forming a metal film 36 in a manner covering a lower surface of the plural structures shown in Fig.9 and then forming a patterned resist film 38 on a lower surface of the metal film 36. The metal film 36 is patterned to be formed into the wiring parts 24A, 24B in a subsequent step shown in Fig. 11. The metal film 36 is formed by, for example, a sputtering method. For example, the metal film 36 may be a Ni/Au layered film having a Ni layer and a Au layer formed on the insulating film 12 in this order. The resist film 38 serves as a mask when forming the wiring parts 24A, 24B by using an anisotropic etching method. The areas at which the resist film 38 is formed correspond to the positions at which the wiring parts 24A, 24B are to be formed. For example, the resist film 38 may be a dry film resist.

Next, Fig.11 shows a step of forming the wiring parts 24A, 24B by using the resist film 38 as a mask and performing anisotropic etching on the metal film 36 until the insulating film 12 formed on the lower surface of the base material 30 is exposed. Thereby, the wiring pattern 13 comprising the via part 23A and the wiring part 24A and the wiring pattern 14 comprising the via part 24A and the wiring part 24B are formed.

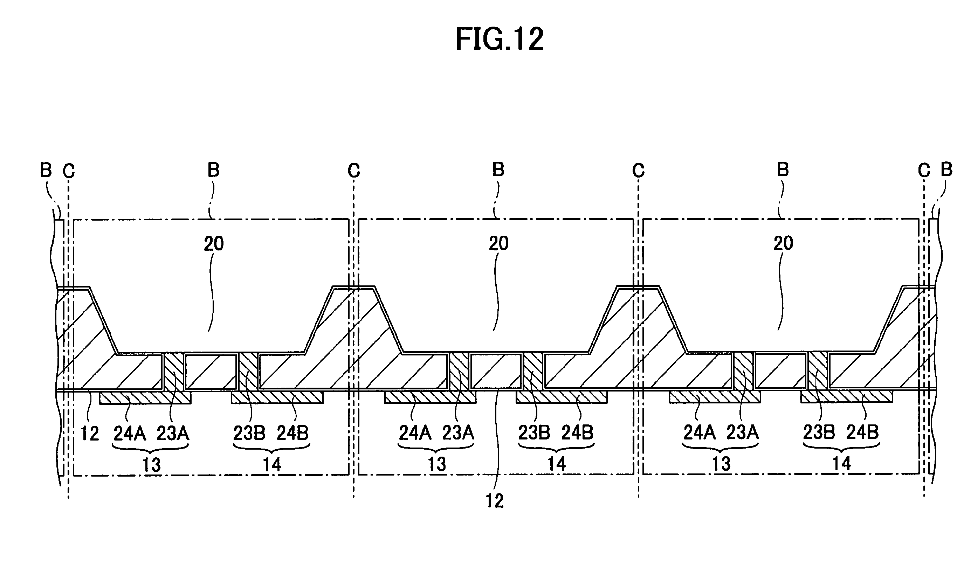

Next, Fig.12 shows a step of removing the resist film 38.

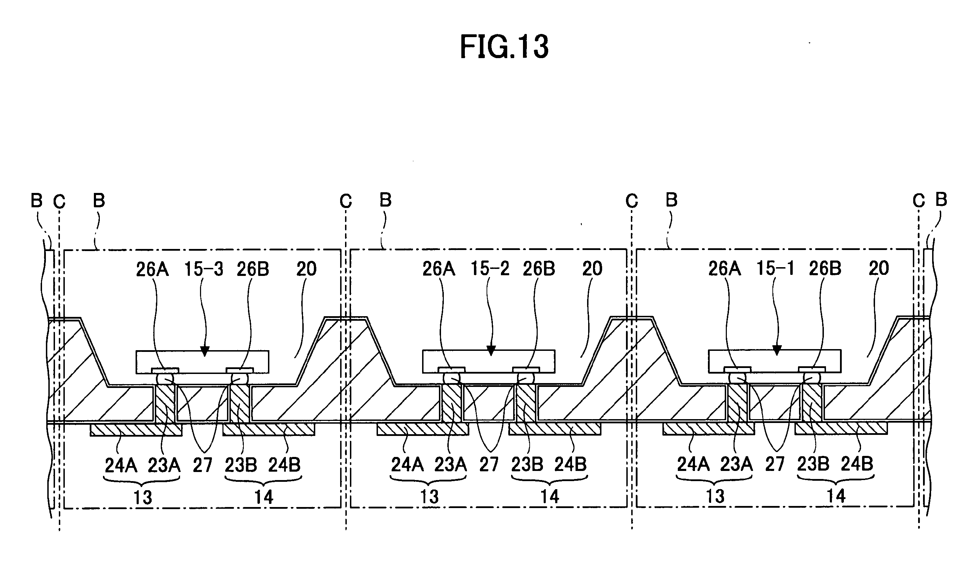

Next, Fig.13 shows a step of forming bumps at an upper end part of the via parts 23A, 23B and melting the bumps 27 for connecting to the electrodes 26A, 26B of the light emitting devices 15-1 to 15-3. Thereby, the light emitting devices 15-1 to 15-3 are electrically connected to the wiring patterns 13, 14. The light emitting devices 15-1 to 15-3 have different luminance and chromaticity. The light emitting devices 15-1 to 15-3 have the same configuration as that of the light emitting device 15 shown in Fig.2. In a case where the light emitting apparatuses 10-1 to 10-3 emit white light, the light emitting devices 15-1 to 15-3 may be, for example, a blue light emitting diode (LED) device.

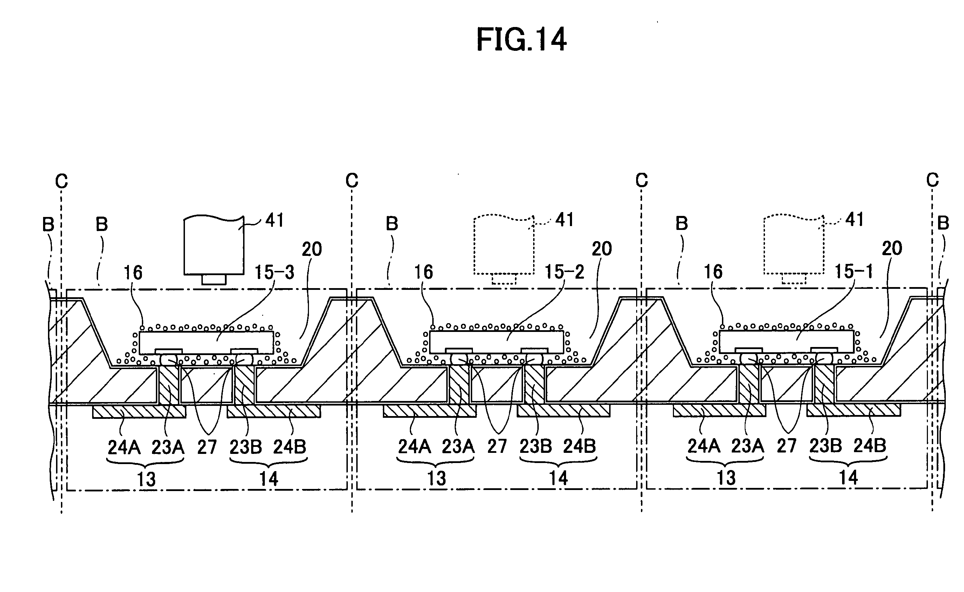

Next, Fig. 14 shows a step of forming a coating containing fluorophor particles 16 in a manner that the coating of fluorophor particles 16 covering the light emitting devices 15-1 through 15-3 has a substantially even thickness (fluorophor particle formation step). In this step, the coating with fluorophor particles 16 is applied while performing illumination with the light emitting devices 15-1 through 15-3 in order by sequentially applying voltage between the electrodes 26A, 26B and measuring the luminances and chromaticities of the light of the individual light emitting devices 15-1 through 15-3 transmitted through the fluorophor particles coating 16 by using a measuring apparatus 41. Thereby, the fluorophor particle coatings 16 covering the light emitting devices 15-1 through 15-3 are formed having a substantially even thickness. Whether the fluorophor particle coatings are formed with a substantially even (uniform) thickness is determined based on the results of the luminance and chromaticity measured by the measuring apparatus 41.

By forming the fluorophor particle coating 16 covering the light emitting devices 15-1 through 15-3 with a substantially even thickness, the inconsistency of luminance and chromaticity of the light emitted from the light emitting apparatuses 10-1 through 10-3 can be restrained.

For example, the fluorophor particle coating 16 may be formed by a spray coating method. The measuring apparatus 41 is, for example, a chromameter (e.g. CS-200, manufactured by Konica Minolta Sensing Inc.). For example, in a case where the light emitting apparatus 10 emits white light, the fluorophor particles may be fluorophor that emits yellow light. YAG fluorophor may be used as the fluorophor that emits yellow light. The average particle diameter of the fluorophor particles contained in the fluorophor particle coating 16 is, for example, 20 µm.

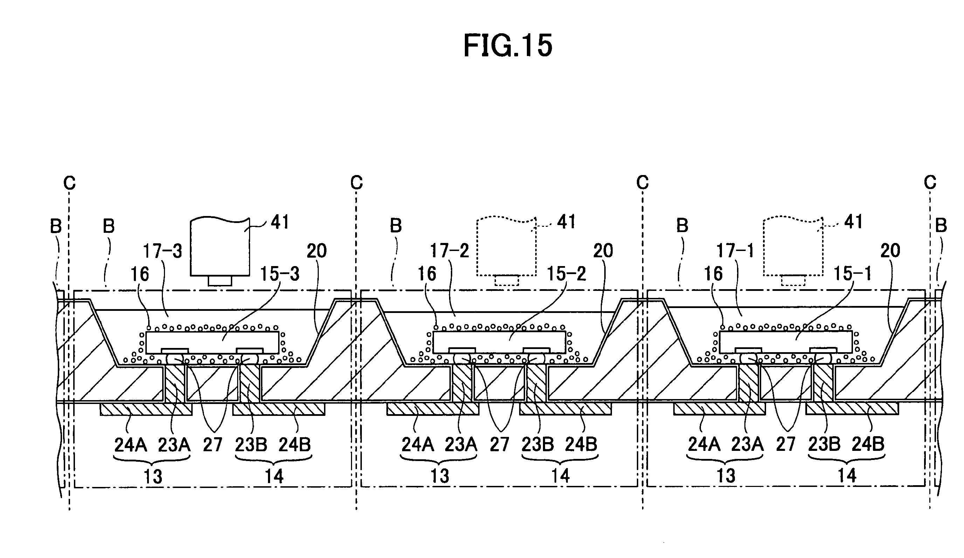

Next, Fig.15 shows a step of forming transparent resins 17-1 through 17-3 covering the fluorophor particle coating 16 so that the light transmitted through the transparent resin 17-1 through 17-3 have a predetermined luminance and chromaticity (transparent resin formation step). In this step, the transparent resins 17-1 through 17-3 are formed while performing illumination with the light emitting devices 15-1 through 15-3 in order by sequentially applying voltage between the electrodes 26A, 26B and measuring the luminance and chromaticity of the light transmitted through the individual transparent resins 17-1 through 17-3 (light emitted by the light emitting devices 15-1 through 15-3) by using the measuring apparatus 41. Thereby, the light transmitted through the transparent resin 17-1 through 17-3 can have a predetermined luminance and chromaticity.

Since the transparent resins 17-1 through 17-3 can be formed so that the light transmitted through transparent resins 17-1 through 17-3 can attain a predetermined luminance and chromaticity by performing illumination with the light emitting devices 15-1 through 15-3 in order, the luminance and chromaticity of the light emitted by the light emitting apparatus 10-1 through 10-3 can be easily adjusted.

Except for the transparent resins 17-1 through 17-3 being formed with different thicknesses, the transparent resins 17-1 through 17-3 have the same configuration as that of the transparent resin 17 illustrated in Fig.2. The transparent resins 17-1 through 17-3 is formed by, for example, an inkjet method.

By forming the transparent resins 17-1 through 17-3 with an inkjet method, the control for adjusting the thickness of the transparent resins 17-1 through 17-3 can be performed easily.

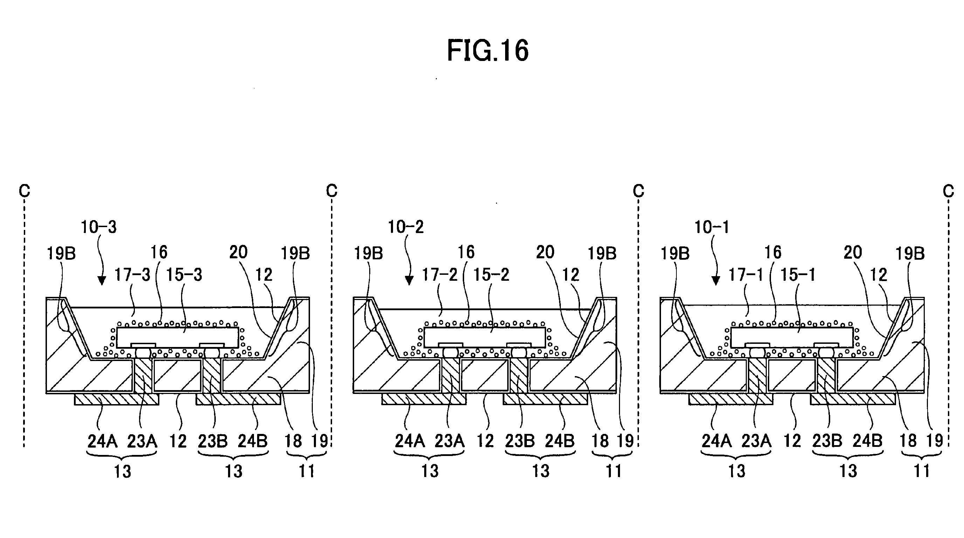

Next, Fig. 16 shows a step of cutting the plural structures of Fig.15 along the cutting areas C. Thereby, plural light emitting apparatuses 10-1 through 10-3 having predetermined luminance and chromaticity can be manufactured. The cutting of the plural structures shown in Fig. 15 is performed, for example, by using a dicer.

With the above-described method of manufacturing a light emitting apparatus according to an embodiment of the present invention, the luminance and chromaticity of the light emitted by the light emitting apparatuses 10-1 through 10-3 can be easily adjusted by performing illumination with the light emitting devices 15-1 through 15-3 in order by applying voltage between the electrodes 26A, 26B and measuring the luminance and chromaticity of the light transmitted through the individual transparent resins 17-1 through 17-3 (light emitted by the light emitting devices 15-1 through 15-3) by using the measuring apparatus 41 so that the measured results exhibit a predetermined luminance and chromaticity.

It is to be noted that, although the light emitting devices 15-1 through 15-3 of the above-described light emitting apparatuses 10, 10-1 through 10-3 are described as being connected to the wiring patterns 13, 14 by the flip chip method, the light emitting apparatuses 10, 10-1 through 10-3 may alternatively be configured having the light emitting devices 15-1 through 15-3 connected to the wiring patterns 13, 14 by a wire bonding method.

Furthermore, a reflecting member (reflector), which can reflect the light emitted by the light emitting devices 15, 15-1 through 15-3, may be provided to the inner wall 19B to which the insulating film 12 is formed. By providing the reflecting member to the inner wall 19B, the light emitting efficiency of the light emitting apparatuses 10, 10-1 to 10-3 can be improved.

Hence, with the method of manufacturing a light emitting apparatus according to an embodiment of the present invention, the luminance and chromaticity of the light emitted by the light emitting apparatus can be easily adjusted.

Further, the present invention is not limited to these embodiments, but variations and modifications may be made without departing from the scope of the present invention.

## Claims

1. A method of manufacturing a light emitting apparatus including a light emitting device and a light emitting device installing body having a concave part for installing the light emitting device therein, the method **characterized by** comprising the steps of:
a) forming a coating of a plurality of fluorophor particles covering the light emitting device installed in the concave part; and
b) forming a transparent resin covering the plural fluorophor particle coating;
wherein step b) includes a step of performing illumination with the light emitting device so that the light emitted from the light emitting apparatus has a predetermined luminance and chromaticity.

2. The method of manufacturing a light emitting apparatus as claimed in claim 1, **characterized in that** step a) includes a step of forming the coating of the plural fluorophor particles with a substantially even thickness.

3. The method of manufacturing a light emitting apparatus as claimed in claim 1, **characterized in that** the transparent resin is formed by an inkjet method.
